# EUROPÄISCHE PATENTANMELDUNG

(11) **EP 1 400 747 A2**
(43) Veröffentlichungstag der Anmeldung: **24.03.2004**
(21) Anmeldenummer: 03020117.2
(22) Anmeldetag: 05.09.2003
(51) Int. Cl.: F21S 8/10, F21V 7/00

(54) **Scheinwerfer mit pyramidenstumpfförmigen Reflektorstrukturen**

(30) Priorität: 18.09.2002 DE 10243421
(71) Anmelder: DaimlerChrysler AG, 70567 Stuttgart (DE)
(72) Erfinder: Moisel, Jörg, 89231 Neu-Ulm (DE); Pressmar, Kurt, 89077 Ulm (DE); Rode, Mandfred, 89250 Senden (DE)

(57) **Zusammenfassung**

Die Erfindung betrifft einen Scheinwerfer mit einer Stromzuleitung, einem Trägerkörper (21), einem darauf angeordneten Array von Einzellichtquellen wie z.B. LED's (25) mit den Einzellichtquellen jeweils zugeordneten Reflektorstrukturen, wobei die Reflektorstrukturen im wesentlichen durch segmentartig zusammengesetzte ebene Flächen aufweisen und somit beispielsweise die Form von Pyramidenstümpfen (23) zeigen.
Ferner betrifft die Erfindung eine Reflektorstruktur für arrayförmig angeordnete Einzellichtquellen, die segmentartig zusammengesetzte ebene Flächen, z.B in Form eines oder mehrerer Pyramidenstümpfe, aufweist.

## Beschreibung

Die Erfindung betrifft einen aus mehreren Einzellichtquellen aufgebauten Scheinwerfer, wobei jede der Einzellichtquellen eine separaten Reflektorstruktur aufweist bzw. die Reflektorstrukturen für die Scheinwerfer.

In jüngerer Zeit haben Scheinwerfer, bei denen die Einzellichtquellen auf einem ebenen Trägerkörper einander benachbart angeordnet sind, weite Verbreitung gefunden. Die geringe Bauhöhe derartiger Scheinwerfer macht sie insbesondere für den Einsatz in Umgebungen mit Restriktionen hinsichtlich des zur Verfügung stehenden Bauraumes wie z. B. in Fahrzeugen zu interessanten Kandidaten.

Ein derartiger Scheinwerfer als Fahrzeuglichtquelle wird beispielsweise in der DE 201 15 799 U1 beschrieben. In der genannten Schrift wird eine Fahrzeugscheinwerfer vorgestellt, der im wesentlichen aus einem Array von auf einem gemeinsamen Trägerkörper montierten LEDs besteht. Dabei sind die LEDs jeweils einzeln für sich mit beispielsweise parabolischen Reflektoren versehen.

Ein wesentlicher Nachteil dieser Anordnung besteht in der inhomogenen Intensitätsverteilung des emittierten Lichtes über die Fläche des LED-Arrays.

Um mit diesem Scheinwerfer eine gleichmäßige Ausleuchtung zu erreichen, muss den Einzelreflektoren entweder jeweils für sich oder allen gemeinsam eine aufwendige Optik vorangeschaltet werden, die zusätzlichen Bauraum beansprucht und eine zusätzliche Abschwächung des von den LED's emittierten Lichts verursacht.

Es ist somit Aufgabe der vorliegenden Erfindung, einen aus Einzellichtquellen bestehenden Scheinwerfer anzugeben, der bei einfacher Herstellung eine hohe Qualität des emittierten Lichtes aufweist. Es ist ferner Aufgabe der Erfindung, eine Reflektorstruktur anzugeben, die die o. g. Vorteile aufweist.

Diese Aufgabe wird durch die Vorrichtung mit den in Anspruch 1 und 9 beschriebenen Merkmalen gelöst; die in den Unteransprüchen beschriebenen Merkmale stellen vorteilhafte Weiterbildungen der Erfindung dar.

Erfindungsgemäß zeigen die den Einzellichtquellen zugeordneten Reflektorstrukturen segmentweise ebene Flächen. Anschaulich lässt sich eine mögliche Ausgestaltungsform der Reflektorstruktur als Pyramidenstumpf mit einer regelmäßigen Grundfläche darstellen. Hierbei befindet sich die Einzellichtquelle auf der Deckfläche des Pyramidenstumpfes. Die Grundfläche des Pyramidenstumpfes ist so zu wählen, dass damit ein Array aufgebaut werden kann, der eine Fläche vollständig ausfüllt; also beispielsweise als Dreieck, Quadrat, Rechteck, Sechseck usw. bzw. Kombinationen daraus. Diese Strukturen sind einfach und somit kostengünstig herstellbar. Damit wird es möglich, die gesamte Oberfläche des Arrays lückenlos mit den Lichtaustrittsflächen der Reflektorstrukturen auszufüllen. Auf diese Weise ist es möglich, bei Bedarf eine ausreichend homogene Verteilung der Lichtintensität über die Gesamtfläche des Arrays zu erreichen und die Qualität des von dem erfindungsgemäßen Scheinwerfer emittierten Lichtstrahles zu steigern. Darüber hinaus werden für die gleiche Anzahl von Einzellichtquellen bei gleicher Bauhöhe des Scheinwerfers bis zu 24 Prozent weniger Fläche benötigt; damit lässt sich die Gesamtgröße des erfindungsgemäßen Scheinwerfers deutlich verringern.

Eine besonders vorteilhafte und einfache Ausgestaltung der Erfindung besteht darin, dass die Reflektorstrukturen als vierseitige Pyramidenstümpfe mit quadratischer bzw. rechteckiger Grundfläche ausgebildet sind. Somit wird eine zeilen- bzw. spaltenweise Anordnung der Einzellichtquellen erheblich erleichtert und die Herstellung des erfindungsgemäßen Scheinwerfers wird vereinfacht und damit verbilligt. Für eine optimale Gestaltung der Reflektorstruktur sind die beiden folgenden Aspekte wesentlich:

Erstens ist für eine maximale Effizienz der Reflektorstruktur vorteilhaft, dass für einen möglichst großen Anteil der von der Einzellichtquelle ausgehenden Strahlen Totalreflexion an der Reflektorstruktur auftritt.

Zweitens ist es für eine gute Ausricht- und Fokussierbarkeit des Scheinwerfers wünschenswert, dass die aus den Reflektorstrukturen austretenden Teillichtbündel eine wohldefinierte Strahlcharakteristik aufweisen und sich insbesondere mit wachsendem Abstand vom Scheinwerfer nicht zu stark aufweiten.

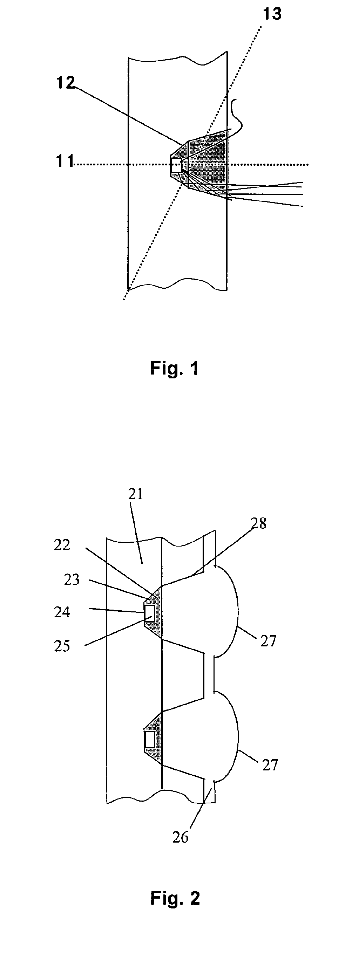

Beide Anforderungen werden durch die Gestaltung der Reflektorstrukturen als zwei oder mehrere aufeinandergesetzte Pyramidenstümpfe mit unterschiedlichen Spitzwinkeln, wie in Figur 1 dargestellt, erfüllt. Hierbei weist der der Einzellichtquelle nächstgelegene Pyramidenstumpf einen vergleichsweise großen Öffnungswinkel auf. Somit wird erreicht, dass auch die in einem großen Winkel zur optischen Achse 11 austretenden Teilstrahlen auf die Reflektoroberfläche 12 unter einem großen Winkel zum Einfallslot 13 auftreffen. Damit sind im allgemeinen die Bedingungen für Totalreflexion an der Grenzfläche erfüllt. Der sich direkt anschließende zweite Pyramidenstumpf weist einen geringeren Öffnungswinkel auf; die ihn erreichenden Teilstrahlen erfüllen aufgrund der gewählten Geometrie der Reflektorstruktur weitgehend die Bedingung für Totalreflexion an der Grenzfläche; ferner wird hierdurch eine weitere Verbesserung der Strahlqualität erreicht. Für eine weitere Optimierung der Strahlqualität ist das Aufbringen weiterer Pyramidenstümpfe vorteilhaft. Darüber hinaus verringert sich durch diese Wahl der Reflektorstruktur die Gesamtquerschnittsfläche des Einzelreflektors und somit der Platzbedarf der Einzellichtquellen; dadurch wird eine höhere Packungsdichte der Einzellichtquellen auf dem Scheinwerferarray möglich.

Es hat sich zur Erhöhung der Reflektivität der Reflektorstruktur bewährt, diese mit einer reflektierenden Beschichtung zu versehen. Das Aufdampfen von Metallisierungs- wie beispielsweise Goldschichten auf Materialien ist ein etablierter und technologisch beherrschter Prozess. Es kann hier in vorteilhafter Weise angewendet werden.

Eine besonders vorteilhafte Wahl für die Einzellichtquellen stellen LEDs dar. Sie sind mittlerweile am Markt in fast allen gewünschten Farben erhältlich und stellen aufgrund ihrer geringen Wärmeentwicklung bei gleichzeitig hoher Lichtausbeute und geringer Leistungsaufnahme optimale Eigenschaften für die zu lösende Aufgabe zur Verfügung. LEDs sind schnell schaltbar und als gebondete Dies u. a. aufgrund ihrer herstellungsbedingten Rechteckform ausgesprochen einfach zu flächigen Arrays integrierbar. Ihr hohes Maß an Miniaturisierbarkeit ermöglicht in Verbindung mit den beschriebenen Reflektorstrukturen die Realisation eines extrem kompakten Scheinwerfers insbesondere für automobile Anwendungen.

Auch im infraroten Spektralbereich sind zwischenzeitlich LEDs in guter Qualität verfügbar; aufgrund der kurzen Schaltzeiten dieser Bauelemente und der bereits oben beschriebenen vorteilhaften Eigenschaften bspw. bzgl. Bauhöhe und Leistungsaufnahme sind sie für den Einsatz in Sonderanwendungen wie z. B. im Infrarotscheinwerfer eines Infrarot-Nachtsichtsystems besonders geeignet.

Aufgrund seiner für die erfindungsgemäße Anwendung ausgesprochen positiven Materialeigenschaften erscheint Silizium bzw. eine Siliziumverbindung als Material für den Trägerkörper besonders geeignet. Die Prozessierung und Mikrostrukturierung von Silizium zählt zu den etablierten Verfahren der Halbleiter- und Mikrosystemtechnik. Die beschriebenen Reflektorstrukturen lassen sich fakultativ auch in einfacher Weise in Siliziumwafern durch den Einsatz von Ätzverfahren realisieren; darüber hinaus lassen sich auf die Siliziumstruktur - ggf. nach einer Passivierung durch Oxidation - Leiterbahnen zur Kontaktierung der Einzellichtquellen problemlos aufbringen. Diese Leiterbahnen können beispielsweise in Gold oder Aluminium mit den bekannten Verfahren der Photolithographie hergestellt werden.

Insbesondere bei der Verwendung von LEDs als Einzellichtquellen ist es für eine maximale Lichtausbeute notwendig, die Totalreflexion an der Grenzfläche Halbleiterkristall/Luft zu minimieren. Eine geeignete Maßnahme hierzu besteht darin, die Reflektorstrukturen mit den darin befindlichen LEDs mit einem in seiner Brechzahl angepassten und für das emittierte Licht transparenten Material, wie beispielsweise einem Polymer, auszugießen; durch den im Vergleich zu einer Halbleiter/Luft-Grenzfläche geringen Brechzahlunterschied wird der Anteil des an der Grenzfläche total reflektierten Lichtes minimiert.

Die Abstrahleigenschaften des beschriebenen Scheinwerfers lassen sich weiter verbessern, wenn vor die Austrittsfläche des Lichtes aus der Reflektorstruktur zusätzliche optische Elemente, wie beispielsweise Linsen, vorgesehen werden. So lässt sich z. B. durch die vorgeschaltete Linse ein durch einen Bondpad auf der Oberfläche des LEDs hervorgerufene dunkler Fleck noch besser kompensieren und damit eine homogene Emission von Licht über den gesamten Scheinwerferquerschnitt sicherstellen.

Figur 2 zeigt eine besonders vorteilhafte Ausführungsform der Erfindung. In der genannten Figur ist ein Querschnitt durch einen erfindungsgemäßen Scheinwerfer dargestellt. Die Scheinwerferstruktur besteht hier im wesentlichen aus einem Trägerkörper 21 und einer Frontplatte 26. In den Trägerkörper 21 sind die pyramidenstumpfförmigen Reflektorstrukturen beispielsweise durch ein Ätzverfahren eingebracht; im Bereich der Deckfläche 24 der Pyramidenstümpfe 23 befinden sich als lichtemittierende Elemente die LEDs 25, die, wie bereits weiter vorne beschrieben, unter vorteilhafter Ausnutzung der Eigenschaften des Siliziums kontaktiert sind. Die Pyramidenstümpfe 23 im Trägerkörper 21 sind mit einem in der Brechzahl angepassten Füllmaterial 22 in der Weise ausgegossen, dass sich insgesamt eine plane Oberfläche des Trägerkörpers 21 ergibt. Auf den Trägerkörper 21 aufgesetzt bzw. mit diesem verklebt ist die Frontplatte 26. Sie trägt auf der dem Trägerkörper zugewandten Seite in der Querschnittsfläche angepasste Pyramidenstümpfe 28, deren Öffnungswinkel geringer ist als der Öffnungswinkel der in den Trägerkörper 21 eingeätzten Pyramidenstümpfe 23. Besonders vorteilhaft ist es, die Frontplatte 26 als monolithisches Element aus demselben Material herzustellen, mit dem auch die Pyramidenstümpfe 23 im Trägerkörper 21 ausgegossen sind. Damit wird die Totalreflexion an der Grenzfläche Trägerkörper 21 und Frontplatte 26 minimiert. Darüber hinaus erhöht es die Effektivität der Reflektorstruktur, die Flanken der Pyramidenstümpfe 28 der Frontplatte beispielsweise mit einer Goldschicht zu bedampfen, um die Reflektivität zu erhöhen. Das aus den LEDs austretende Licht wird durch die beschriebene Reflektorstruktur in seiner Strahlcharakteristik geeignet vorkonditioniert und verlässt die Frontplatte 26 auf der dem Trägerkörper 21 abgewandten Seite durch strahlformende Elemente 27, in diesem Fall sphärische Linsen.

Die anhand der Figuren dargestellten Ausführungsformen stellen nur eine Möglichkeit aus einer Vielzahl von möglichen Bauweisen dar. Insbesondere sind selbstverständlich Abweichungen hinsichtlich der Dimensionierungen und Winkel der Reflektorstrukturen möglich. Ferner ist es zur Verringerung der Bauhöhe des beschriebenen Scheinwerfers selbstverständlich auch denkbar, die strahlformenden Elemente 27 nicht als sphärische, sondern bspw. als Fresnellinsen auszubilden.

Aufgrund ihres modularen Aufbaus ist die beschriebene Anordnung fertigungstechnisch ausgesprochen einfach herzustellen und damit kostengünstig realisierbar.

## Patentansprüche

1. Scheinwerfer mit einer Stromzuleitung, einem Trägerkörper, einem darauf angeordneten Array von Einzellichtquellen mit den Einzellichtquellen jeweils zugeordneten Reflektorstrukturen
**dadurch gekennzeichnet,**
**dass** zumindest einzelne der Reflektorstrukturen im wesentlichen segmentartig zusammengesetzte ebene Flächen aufweisen.

2. Scheinwerfer nach Anspruch 1
**dadurch gekennzeichnet,**
**dass** die Reflektorstrukturen Pyramidenstümpfe aufweisen.

3. Scheinwerfer nach einem der vorhergehenden Ansprüche
**dadurch gekennzeichnet,**
**dass** die Reflektorstrukturen zwei aufeinandergesetzte Pyramidenstümpfe mit unterschiedlichen Öffnungswinkeln aufweisen.

4. Scheinwerfer nach einem der vorhergehenden Ansprüche
**dadurch gekennzeichnet,**
**dass** die Reflektorstrukturen ganz oder teilweise mit einem das von den Einzellichtquellen emittierte Licht reflektierenden Material beschichtet sind.

5. Scheinwerfer nach einem der vorhergehenden Ansprüche
**dadurch gekennzeichnet,**
**dass** es sich bei mindestens einer der Einzellichtquellen um eine LED handelt.

6. Scheinwerfer nach einem der vorhergehenden Ansprüche
**dadurch gekennzeichnet,**
**dass** der Trägerkörper mindestens teilweise aus Silizium oder einer Siliziumverbindung besteht.

7. Scheinwerfer nach einem der vorhergehenden Ansprüche
**dadurch gekennzeichnet,**
**dass** Reflektorstrukturen ganz oder teilweise mit einem für das von den Einzellichtquellen emittierte Licht durchlässigen Material ausgefüllt sind.

8. Scheinwerfer nach einem der vorhergehenden Ansprüche
**dadurch gekennzeichnet,**
**dass** vor den Reflektorstrukturen strahlformende Elemente wie bspw. Linsen angeordnet sind.

9. Reflektorstruktur für arrayförmig angeordnete Einzellichtquellen
**dadurch gekennzeichnet,**
**dass** sie segmentartig zusammengesetzte ebene Flächen insbesondere in Form eines oder mehrerer Pyramidenstümpfe aufweist.
